# EUROPEAN PATENT APPLICATION

(11) **EP 1 944 653 A2**
(43) Date of publication of application: **16.07.2008**
(21) Application number: 07114510.6
(22) Date of filing: 17.08.2007
(51) Int. Cl.: G03F 7/20

(54) **Illumination system of a microlithographic exposure system**

(30) Priority: 26.09.2006 US 826951 P
(71) Applicant: Carl Zeiss SMT AG, 73447 Oberkochen (DE)
(72) Inventor: Fürter, Gerd, 73479, Ellwangen (DE); Bieling, Stig, 73430, Aalen (DE); Fiolka, Damian, 73447, Oberkochen (DE); Zimmermann, Jörg, 73434, Aalen (DE); Pazidis, Alexandra, 73431, Aalen (DE); Totzeck, Michael, Schwäbisch Gmünd 73525 (DE)
(74) Representative: Frank, Hartmut

(57) **Abstract**

The present invention relates to an illumination system of a microlithographic exposure system. The illumination system has an optical axis and comprises: at least one light mixing rod made from a cubic crystal material and having an entry face, an exit face and side faces, wherein said light mixing rod mixes light of a light beam, said light beam being emitted by a light source during operation of said microlithographic exposure system, via multiple internal reflections at said side faces and wherein said entry face and said exit face of said light mixing rod are oriented substantially perpendicular to a [100]-crystal axis of said cubic crystal material, and an optical system mounted along said optical axis upstream of said light mixing rod and transmitting light of said light beam to said entry face of said light mixing rod, wherein said optical system comprises at least two lenses made from a cubic crystal material, wherein said at least two lenses have its [111]-crystal axes aligned along said optical axis and are rotated against each other with respect to said optical axis.

## Description

### BACKGROUND OF THE INVENTION

### 1. Field of the invention

The present invention relates to an illumination system of a microlithographic exposure system.

### 2. Description of the related art

Microlithography is used in the fabrication of microstructured components like integrated circuits, LCD's and other microstructured devices. The microlithographic process is performed in a so-called microlithographic exposure system comprising an illumination system and a projection lens. The image of a mask (or reticle) being illuminated by said illumination system is projected, through said projection lens, onto a resist-covered substrate, typically a silicon wafer bearing one or more light-sensitive layers and being provided in the image plane of said projection lens, in order to transfer the circuit pattern onto the light-sensitive layers on the wafer.

It is a problem to transport light in the illumination system through the system in a well-defined polarization state due to various depolarizing or polarization-modifying effects, in particular intrinsic or stress-induced birefringence in the optical elements or phase shifts occurring at reflecting elements.

Several approaches have been made to address this issue. Some approaches include e.g. certain arrangements in a light mixing rod, which is used in the illumination system for mixing and homogenizing the light passing therethrough, such as composing such light mixing rod of two subsystems having a retarding system like a half-wave-plate between them. Such an arrangement is disclosed in WO 03/077011 A1 and US 2005/0094268 A1.

A further exemplarily approach includes providing the light mixing rod with a coating in order to preserve the polarization state, as disclosed in the not yet published US-provision application having the serial number 60/684,602 and being filed on May 25 2005, the disclosure of which shall hereby be incorporated by reference in the present application.

Furthermore, e.g. US 2004/0105170 A1 and WO 02/093209 A2 inter alia disclose for the purposes of reducing the adverse influence of intrinsic birefringence in an objective with fluoride crystal lenses to arrange fluoride crystal lenses of the same crystal cut in mutually rotated relationship (referred to as 'clocking') and to combine together a plurality of groups of such arrangements with different crystal cuts (for example of (100)-lenses and (111)-lenses).

The above citations are examplarily and not exhaustive. Further, they do not constitute any declaration on their relevance for this application.

### SUMMARY OF THE INVENTION

It is an object of the present invention to provide an illumination system of a microlithographic exposure system, which enables an enhanced preservation of the polarization state of linear polarized light passing through the illumination system.

According to one aspect of the present invention, an illumination system of a microlithographic exposure system has an optical axis and comprises:
- at least one light mixing rod made from a cubic crystal material and having an entry face, an exit face and side faces, wherein said light mixing rod mixes light of a light beam, said light beam being emitted by a light source during operation of said microlithographic exposure system, via multiple internal reflections at said side faces and wherein said entry face and said exit face of said light mixing rod are oriented substantially perpendicular to a [100]-crystal axis of said cubic crystal material; and
- an optical system mounted along said optical axis upstream of said light mixing rod and transmitting light of said light beam to said entry face of said light mixing rod, wherein said optical system comprises at least two lenses made from a cubic crystal material, wherein said at least two lenses have its [111]-crystal axes aligned along said optical axis and are rotated against each other with respect to said optical axis.

The present invention achieves an enhanced preservation of the polarization state by combining a light mixing rod being oriented with both its entry face and its exit face substantially perpendicular to its [100]-crystal axis with the relative rotation ("clocking"), in the optical system mounted upstream of said light mixing rod, of at least two lenses having its [111]-crystal axes aligned along said optical axis.

The clocking of such so-called (111)-lenses made from e.g. fluoride crystal material serves to compensate for the well-known effect of intrinsic birefringence in this material. The invention is now based on the consideration that in the envisaged illumination system, said compensation is particular favourable and effective in the optical path upstream of the light mixing rod. This is because, in general and for arbitrary polarization states at the entry side of the light mixing rod, the light mixing rod has a strong depolarizing influence, since phase shifts due to total reflections occurring at the side faces of the light mixing rod accumulate to retardation distributions which would significantly disturb a desired polarization distribution, if no suitable countermeasures are taken.

As already discussed above, such countermeasures may include (according to WO 03/077011 A1 and US 2005/0094268 A1) composing the light mixing rod of two rods having a half-wave-plate between them. The present invention, however, follows another concept to avoid the need for providing at least two light mixing rods (although such a subdividing of the rod into two or more rods is still possible and within the scope of the present invention). As a result of the presence of at least two clocked (111)-lenses in the optical system upstream of the light mixing rod and the accompanying, at least partial compensation of the intrinsic birefringence in said optical system, a better defined orientation of polarization of the light coming from the light source (laser) can be achieved when entering said light mixing rod. In particular, this makes it possible to use the light mixing rod in its "Eigen-states" of any existing stress-induced birefringence, as explained below in more detail.

The invention also accounts for the fact that the use of (111)-CaF₂-lenses is preferred and desirable due to aspects of relatively good availability and relatively low costs. As to the light mixing rod being oriented with both its entry face and its exit face substantially perpendicular to its [100]-crystal axis, a further advantage is that such a rod can be manufactured with a relatively good (i.e. low) micro-roughness and the edges of the rod can be mechanically treated and processed (e.g. cut or polished) with enhanced precision if compared to arbitrary orientations of the rod, which may be attributed to the fact that any cleaving of the crystal material easier occurred along its natural crystallographic planes.

According to an embodiment of the present invention, said side faces of said light mixing rod are oriented substantially perpendicular to a [100]-crystal axis of said cubic crystal material of said light mixing rod.

By orienting, in addition to said entry face and said exit face, also said side faces of the light mixing rod substantially perpendicular to the [100]-crystal axis, a particular advantageous orientation is selected for the light mixing rod in combination with the rotating ("clocking") of the at least two lenses having its [111]-crystal axes aligned along said optical axis with respect to the preservation of the polarization state during operation of the inventive illumination system.

This is based on the consideration that if the light mixing rod is irradiated with linear polarized light having its direction of polarization parallel or perpendicular to the side faces of the light mixing rod, any non-desired influence of the so-called stress-induced birefringence being present in the cubic crystalline material of light mixing rod may be reduced or even eliminated. This stress-induced birefringence occurs in the cubic crystalline material as a result of the manufacturing process, in particular during cutting the rod from larger blanks of the raw material, e.g. calcium-fluoride (CaF₂).

It has been found that in a rod made of cubic crystal material (such as CaF₂) and having all its side faces as well as its entry face and its exit face of the rod perpendicular to the [100]-crystal axis of the cubic crystal material, the orientation of this stress-induced birefringence, i.e. the direction of the fast or the slow axis, is well-determined and well oriented in such that that this fast or slow axis of the stress-induced birefringence is parallel or perpendicular, respectively, to the side faces of the rod. Therefore, if linear polarized light passes a light mixing rod having its entry face, its exit face and its side faces perpendicular to the [100]-crystal axis in the rod, and if said light has its direction of polarization parallel or perpendicular to the side faces of the light mixing rod, said linear polarized light passes the light mixing rod in the so-called "Eigen-states" of the stress-induced birefringence, which again means that the state of polarization of said light remains unaffected by the stress-induced birefringence in said light mixing rod.

Furthermore, since the preservation of the polarization state requires a well-defined direction of polarization of the light when entering said light mixing rod, the above defined orientation of the light mixing rod is combined, according to the present invention, with the rotating ("clocking") of the at least two lenses having their [111]-crystal axes aligned along said optical axis in the optical system mounted upstream of said rod.

On the other hand, if an intrinsic birefringence being present in the optical system which is mounted upstream of said rod due to the presence of (111)-CaF₂-lenses is not at least substantially compensated, it would affect the well-defined orientation of polarization of the light coming from the light source (laser), and thereby make the above concept of using the light mixing rod in its "Eigen-states" of the stress-induced birefringence more difficult or impossible, since the light when entering the light mixing rod would not anymore be polarized parallel or perpendicular to its side faces, but e.g. elliptically polarized.

According to an embodiment of the present invention, said illumination system comprises exactly one light mixing rod. This results in a relative simple structure and makes use of the effect that an enhanced preservation of the polarization state is also possible according to the invention without subdividing the rod into two rods having a half-wave-plate between them.

According to an embodiment of the present invention, said optical system comprises a zoom objective, an adjustable axicon and an in-coupling optic coupling light of said light beam into said light mixing rod.

According to an embodiment of the present invention, said optical system further comprises an optical assembly mounted along said optical axis downstream of said light mixing rod and including a reticle masking system and a reticle masking objective, said reticle masking objective imaging an intermediate field plane of said reticle masking system onto a reticle plane.

According to an embodiment of the present invention, exactly one lens in said reticle masking objective is made from a cubic crystal material and has its [100]-crystal axis aligned along said optical axis.

According to an embodiment of the present invention said cubic crystal material of said light mixing rod and/or said cubic crystal material of said lenses is a fluoride-crystal material, preferably calcium-fluoride (CaF₂).

According to an embodiment of the present invention, the illumination system comprises in addition to said first light mixing rod a second light mixing rod mounted along said optical axis downstream of said first light mixing rod as well a half-wave-retardation plate, said half-wave-retardation plate being arranged along said optical axis between said first and said second light mixing rod. Said first light mixing rod and said second light mixing rod preferably have substantially identical geometrical dimensions. In a preferred embodiment, said second light mixing rod is also made from cubic crystal material and has a second entry face, a second exit face and second side faces, wherein said second entry face and said second exit face of said second light mixing rod are oriented substantially perpendicular to a [100]-crystal axis of said cubic crystal material. Also, in a preferred embodiment said second side faces of said second light mixing rod are oriented substantially perpendicular to a [100]-crystal axis of said cubic crystal material.

According to an embodiment of the present invention, said first and/or said second side faces are provided with a coating, wherein said coating is prepared such that for linear polarized light of said light beam entering said entry face of said light mixing rod the state of polarization is substantially preserved when leaving said exit face of said light mixing rod.

According to an embodiment of the present invention, said coating is a dielectric coating that causes, for a light beam being reflected thereon while passing said light mixing rod, a phase shift between two orthogonal polarization states in the range from 130° to 230°, more preferably in the range from 155° to 205°, and still more preferably of substantially 180°.

According to an embodiment of the present invention, the illumination system further comprises at least one optical element selected from the group that consists of diffractive optical element, refractive optical element, diffusion panel or grey filter, wherein said at least one optical element consists of or comprises either a fluoride-crystal material, preferably calcium-fluoride (CaF₂), or crystalline quartz (SiO₂).

According to an embodiment of the present invention, the illumination system comprises a diffractive optical element mounted in an object plane of said zoom objective and being made either from a fluoride-crystal material, preferably calcium-fluoride (CaF₂), or crystalline quartz (SiO₂).

According to an embodiment of the present invention, the illumination system comprises a refractive optical element mounted in an exit pupil plane of said zoom objective and being made either from a fluoride-crystal material, preferably calcium-fluoride (CaF₂), or crystalline quartz (Si0₂).

According to an embodiment of the present invention, the illumination system comprises at least one diffusion panel mounted at said entry side of said first and/or second light mixing rod and being made either from a fluoride-crystal material, preferably calcium-fluoride (CaF₂), or crystalline quartz (SiO₂).

According to an embodiment of the present invention, the illumination system comprises at least one grey filter mounted in an exit pupil plane of said zoom objective and having a substrate made either from a fluoride-crystal material, preferably calcium-fluoride (CaF₂), or crystalline quartz (SiO₂).

In a further embodiment of the present invention, the illumination system comprises a polarizer mounted at a position along said optical axis downstream of said light mixing rod and having an extinction ratio a value of which does not exceed a value of 10, more preferably a value of 5. In a preferred embodiment, said extinction ratio does not exceed a value of 2.0, more preferably a value of 1.85, and still more preferably a value of 1.7. The polarizer may in particular be arranged in a pupil plane of a reticle masking objective of said illumination system.

With the above restriction of the extinction ratio of a polarizer being used e.g. in the pupil plane of the REMA-objective to relatively small values, the invention takes account for the fact that the illumination system of the present invention already provides for a relatively good preservation of the state of polarization even without said polarizer. The achieved advantageous effect of the restriction of the extinction ratio of the polarizer is that an undesired intensity variation in field of the light downstream of said polarizer is at least substantially avoided.

In a further embodiment, an intensity filter may be mounted along said optical axis downstream of said light mixing rod. The intensity filter may in particular be arranged directly on said polarizer.

According to an embodiment of the present invention, the illumination system comprises upstream of said light mixing rod a polarization-modulating optical element which transforms an entering light bundle with a linear polarization distribution into an exiting light bundle with an at least approximately tangential polarization distribution. Said polarization-modulating optical element may be made of an optically active crystal material, wherein an optical crystal axis of said optically active crystal material is parallel to said optical axis of said illumination system, and wherein said polarization-modulating optical element has a thickness profile which, as measured in the direction of said optical axis, is variable.

According to this embodiment, regions of different polarization degrees may be provided in the pupil plane downstream of the light mixing rod (i.e. in the pupil plane within the REMA-objective). Such polarization distributions with a locally varying polarization degree or a locally varying residual polarisation may be suitable for the simultaneous imaging of both strongly orientated like line structures and less strongly oriented structures like electrical contacts or peripheral structures.

According to a further aspect of the present invention, an illumination system of a microlithographic exposure system has an optical axis and comprises
- a reticle masking system and a reticle masking objective, said reticle masking objective imaging an intermediate field plane of said reticle masking system onto a reticle plane; and
- a polarizer mounted at a position along said optical axis downstream of said light mixing rod and having an extinction ratio a value of which does not exceed a value of 10, more preferably a value of 5.

This aspect of the present invention accounts for the fact that it has been found that a polarizer having a large extinction ratio causes, if it is arranged e.g. in a pupil plane of the REMA-objective of the illumination system, an undesired intensity variation in field downstream of said polarizer, which is a consequence of the polarization variation in field upstream of said polarizer. Accordingly, also in this aspect an advantageous effect of the restriction of the extinction ratio of the polarizer is that an undesired intensity variation in field of the light downstream of said polarizer is at least substantially avoided.

According to a further aspect of the present invention, an illumination system of a microlithographic exposure system has an optical axis and comprises:
- a light mixing rod having an entry face, an exit face and side faces, wherein said light mixing rod mixes light of a light beam, said light beam being emitted by a light source during operation of said microlithographic exposure system, via multiple internal reflections at said side faces;
- an optical system mounted along said optical axis upstream of said light mixing rod and transmitting light of said light beam to said entry face of said light mixing rod; and
- an optical assembly mounted along said optical axis downstream of said light mixing rod and including a reticle masking system and a reticle masking objective;
- wherein exactly one lens in said reticle masking objective is made from a cubic crystal material and has its [100]-crystal axis aligned along said optical axis.

As a consequence of providing exactly one lens in the reticle masking objective as a [100]-crystal lens, most of the light rays can pass this lens in the Eigen-states of the intrinsic birefringence in the [100]-crystal lens. Furthermore, the fourfold symmetry of this intrinsic birefringence matches with that of the light mixing rod, if the latter is also made from [100]-crystal material. It is thereby possible to achieve (e.g. compared with the use of only one [111]-lens in the reticle masking objective) an improved preservation of the polarization state while using only one [100]-crystal lens, which is also favourable under cost aspects.

Other aspects of the present invention are a method of microlithographically structuring a substrate and a microstructured device.

Further aspects of the present invention can be gathered from the following description and the appended claims.

### BRIEF DESCRIPTION OF THE DRAWINGS

The invention is described in more detail with reference to the following detailed description and based upon preferred embodiments shown in the drawings, in which:
- Fig. 1: shows a schematic illustration of an illumination system according to an embodiment of the present invention;
- Fig. 2a: shows a schematic illustration of the light mixing rod of the illumination system of Fig. 1;
- Fig. 2b,c: show schematic illustrations of further embodiments of a light mixing rod for use in the illumination system of Fig. 1;
- Fig. 3: shows a schematic illustration of an arrangement which can be alternatively used instead of the light mixing rod of Fig. 1;
- Fig. 4a-c: show schematic representations of a polarizer which can be used in a further embodiment of the present invention downstream of the light mixing rod, wherein Fig. 4a is a perspective view and Fig. 4b,c are side sectional views of the principal arrangement of said polarizer;
- Fig. 5a-b: show the dependence of the transmission coefficients Tₛ or Tₚ for different embodiments of a polarizer as shown in Fig. 4;
- Fig. 6: shows a polarization-modulating optical element being arranged in an illumination system according to a further embodiment of the present invention;
- Fig. 7: shows, for an illumination system of the present invention provided with the polarization-modulating optical element of Fig. 6 and for an annular illumination setting, a pupil provided in the pupil plane downstream of the light mixing rod and having regions of different polarization degree together with a schematic representation of the contours of the light mixing rod; and
- Fig. 8: a schematic illustration of an illumination system provided with the polarization-modulating optical element of Fig. 6.

### DETAILED DESRIPTION OF PREFERRED EMBODIMENTS

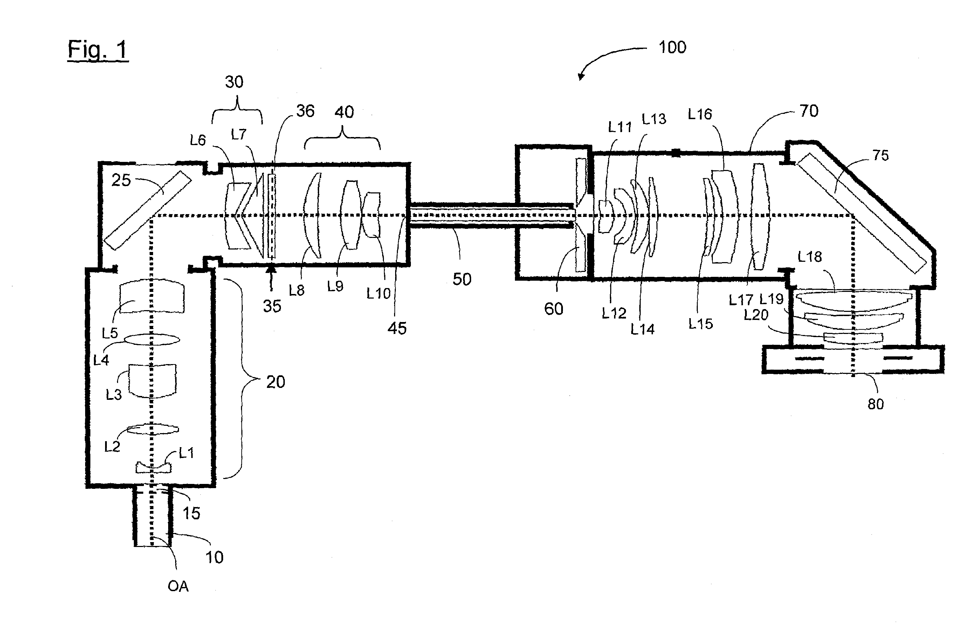

According to Fig. 1, an illumination system 100 of a microlithographic exposure system according to the present invention is schematically illustrated. The illumination system 100 comprises an optical axis OA. During operation of the microlithographic exposure system, a light beam emitted by a light source 10, which may e.g. be an ArF-Excimer Laser having an operating wavelength of 193 nm, enters the illumination system 100. Other light sources like e.g. a KrF-Excimer Laser having an operating wavelength of 248 nm or a F₂-Laser having an operating wavelength of 157 nm are also suitable.

A first diffractive optical element (DOE) 15 is arranged in an object plane of a zoom objective 20. The DOE 15 is preferably made either from a fluoride-crystal material, preferably calcium-fluoride (CaF₂), or crystalline quartz (SiO₂).

The zoom objective 20 comprises an arrangement of lenses (in the exemplarily embodiment five lenses L1-L5), which are just schematically illustrated and which are made from calcium-fluoride such that the [111]-crystal axes are aligned along the optical axis OA but rotated against each other with respect to the optical axis OA as explained further below in more detail.

Following to a mirror 25 for folding the optical path, an adjustable axicon 30 (comprising lenses L6 and L7) and an in-coupling optic 40 (comprising three lenses L8-L10) are arranged.

A refractive optical element 35 is mounted in an exit pupil plane of the zoom objective 20 and is preferably made either from calcium-fluoride (CaF₂) or crystalline quartz (SiO₂). Also shown in Fig. 1 is the position of a grey filter 36 being mounted near the exit pupil plane of the zoom objective 20. The grey filter 36 has a substrate which is preferably also made either from calcium-fluoride (CaF₂) or crystalline quartz (SiO₂).

The light emitted by the light source 10 and reflected by the mirror 25 is coupled into a light mixing rod 50 being arranged downstream of said in-coupling optic 40. A diffusion panel 45 is mounted at an entry side of the light mixing rod 50 and is preferably made from calcium-fluoride (CaF₂) or crystalline quartz (SiO₂).

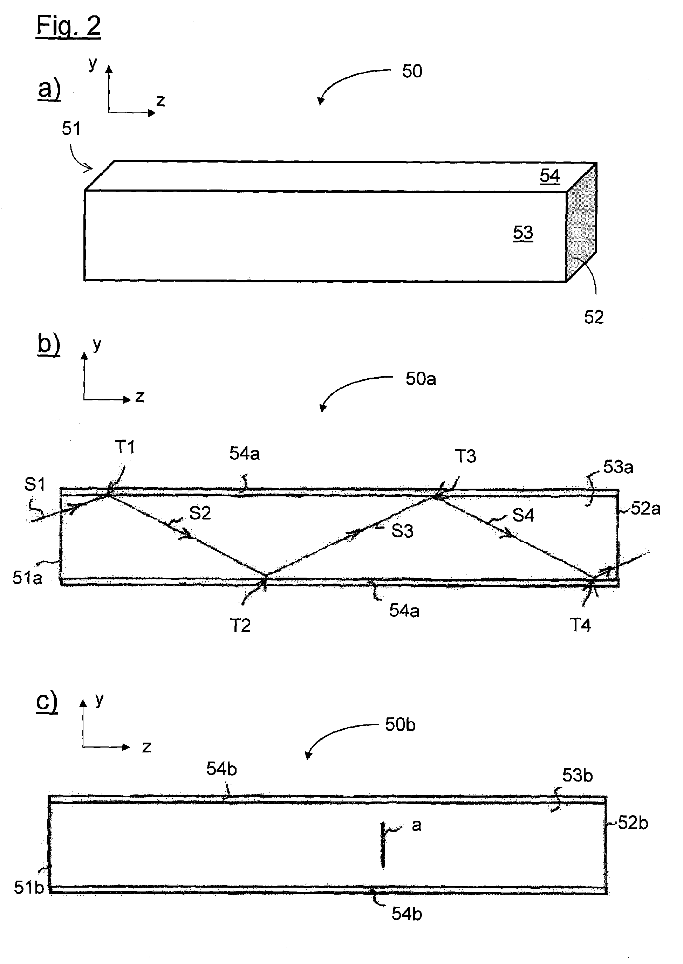

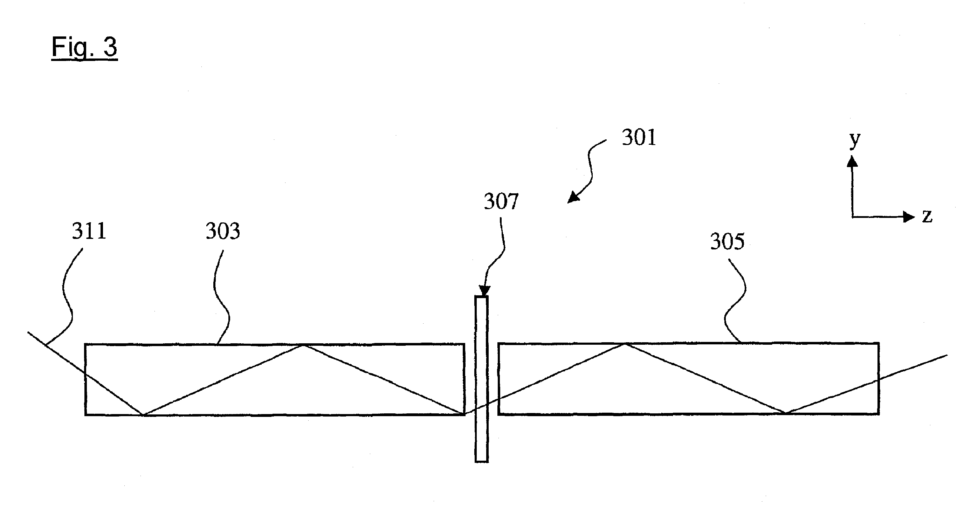

The light mixing rod 50 is made from calcium-fluoride (CaF₂) and has, as schematically shown in Fig. 2a, one entry face 51, one exit face 52 and four side faces (of which only two side faces 53 and 54 can be seen in Fig. 2a), which are all oriented substantially perpendicular to the [100]-crystal axis of the CaF₂-crystal material (which is possible due to the 4-fold symmetry of its cubic crystal structure). More than only one light mixing rod may also be used according to the present invention, as further discussed below with reference to Fig. 3.

The light entering the light mixing rod 50 is mixed and homogenized via multiple internal reflections occurring at the side faces. An intermediate image field is disposed at the exit face 52 of the light mixing rod 50, at which place a reticle-masking system (REMA) 60 is arranged. The reticle-masking system 60 defines an adjustable field diaphragm. Downstream of the reticle-masking system 60 follows a REMA-objective 70. The REMA-objective 70 comprises a group of lenses, in the exemplarily embodiment lenses L11-L20, with a folding mirror 75 being arranged, according to the exemplarily embodiment, in the optical path between the group of lenses L15-L17 and the group of lenses L18-L20, and images the intermediate image field of the reticle-masking system 60 on a reticle 80.

In the embodiment of Fig. 1, the lenses L1-L5 of the zoom objective 20, the lenses L6 and L7 of the axicon 30 and the lenses L8-L10 of the in-coupling optic 40 are made from CaF₂, wherein the [111]-crystal axes are aligned along the optical axis OA and are rotated against each other with respect to this optical axis OA. In Table 1, the respective clocking angles of these lenses are given for a preferred embodiment.

**Table 1:**

| **Lens** | **Crystal axis aligned along OA** | **Azimuth angle [deg.]** |
|---|---|---|
| L1 | [111] | 100 |
| L2 | [111] | 120 |
| L3 | [111] | 50 |
| L4 | [111] | 110 |
| L5 | [111] | 100 |
| L6 | [111] | 40 |
| L7 | [111] | 110 |
| L8 | [111] | 0 |
| L9 | [111] | 30 |
| L10 | [111] | 90 |

In a preferred embodiment, exactly one lens in said reticle masking objective 70 (i.e. lens L11) is made from a cubic crystal material and has its [100]-crystal axis aligned along the optical axis OA.

In a further embodiment, the first two lenses L11 and L12 of the REMA-objective 70 are made from calcium-fluoride, wherein the first lens L11 the [111]-crystal axes is aligned along the optical axis OA, whereas in the second lens L12 of the REMA-objective 70, the [100]-crystal axes is aligned along the optical axis OA (see Table 2).

**Table 2:**

| **Lens** | **Crystal axis aligned along OA** |
|---|---|
| L11 | [111] |
| L12 | [100] |

According to a still further embodiment, the first lenses L11 and L12 of the REMA-objective 70 have their [111]-crystal axes aligned along the optical axis OA while being rotated against each other with respect to the optical axis OA, with the respective clocking angles of these lenses being given in Table 3.

**Table 3:**

| **Lens** | **Crystal axis aligned along OA** | **Azimuth angle [deg.]** |
|---|---|---|
| L11 | [111] | 30 |
| L12 | [111] | 90 |

In the following, further embodiments of light mixing rod in the illumination system 100 of Fig. 1 are described with reference to Fig. 2b and 2c.

According to Fig. 2b, a light mixing rod 50a in an alternate embodiment has its entry face 51a, its exit face 52a and its four side faces oriented substantially perpendicular to the [100]-crystal axis of the CaF₂-crystal material. However, the light mixing rod 50a differs from the light mixing rod 50 of Fig. 2a in so far as the side faces of the light mixing rod are provided with a dielectric coating 54a. This dielectric coating 54a is prepared as disclosed in the above-mentioned US-provision application having the serial number 60/684,602 such that for linear polarized light entering the entry face 51a of the light mixing rod 50a, the coating 54a causes, for a light beam being reflected thereon while passing the light mixing rod 50a, a phase shift between two orthogonal polarization states (i.e. s-polarized state and p-polarized state) of substantially 180°. Accordingly, at each total reflection T1-T4 as illustrated in Fig. 2b, the component of the electric field vector which was flagging in phase before a total reflection is running ahead in phase after the total reflection. As a consequence, the state of polarization of the linear polarized light which enters the entry face 51a of the light mixing rod 50a may be substantially preserved when leaving the exit face 52a.

The dielectric coating 54a is deposited (e.g. by vapour deposition) on the respective side faces of the light mixing rod and consists of a layer system examples of which being given in the following.

A first example of a layer system suited for the dielectric coating 54a is given in the following Table 4. Table 5 is giving the real part (n) and the imaginary part (K) of the complex refractive index of the used layer materials, wherein all the values in these and the following tables are given with the usual error bars, depending on the parameters of the deposition process.

**Table 4:**

| **layer number** | **physical thickness [nm]** | **material** |
|---|---|---|
| Air | | |
| 1 | 68.3 | LaF₃ |
| 2 | 25.3 | Chiolith |
| 3 | 72.8 | LaF₃ |
| 4 | 33.3 | Chiolith |
| 5 | 46.5 | LaF₃ |
| 6 | 38.4 | Chiolith |
| 7 | 23.0 | LaF₃ |
| Substrate | | CaF₂ |

**Table 5:**

| **material** | **n** | **K** |
|---|---|---|
| LaF₃ | 1.67 | 0.0002 |
| Chiolith | 1.36 | 0.0004 |

Another example of a layer system suited for the dielectric coating 54a is given in the following Table 6. Table 7 is giving the real part (n) and the imaginary part (K) of the complex refractive index of the used layer materials.

**Table 6:**

| **layer number** | **physical thickness [nm]** | **material** |
|---|---|---|
| air | | |
| 1 | 61.4 | LaF₃ |
| 2 | 53.5 | MgF₂ |
| 3 | 57.5 | LaF₃ |
| 4 | 40.7 | MgF₂ |
| 5 | 43.0 | LaF₃ |
| 6 | 56.6 | MgF₂ |
| 7 | 20.0 | LaF₃ |
| substrate | | CaF₂ |

**Table 7:**

| **material** | **n** | **k** |
|---|---|---|
| LaF₃ | 1.67 | 0.0002 |
| MgF₂ | 1.44 | 0.0002 |

Another example of a layer system suited for the dielectric coating 54a is given in the following Table 8. Table 9 is giving the real part (n) and the imaginary part (K) of the complex refractive index of the used layer materials.

**Table 8:**

| **layer number** | **physical thickness [nm]** | **material** |
|---|---|---|
| air | | |
| 1 | 48.6 | NdF₃ |
| 2 | 48.7 | Chiolith |
| 3 | 22.4 | NdF₃ |
| substrate | | CaF₂ |

**Table 9:**

| **material** | **n** | **k** |
|---|---|---|
| NdF₃ | 1.73 | 0.0005 |
| Chiolith | 1.36 | 0.0004 |

According to Fig. 2c, a light mixing rod 50b in an alternate embodiment also has its entry face 51b, its exit face 52b and its four side faces oriented substantially perpendicular to the [100]-crystal axis of the CaF₂-crystal material. However, the light mixing rod differs from the light mixing rod 50 of Fig. 2a in so far as the side faces of the light mixing rod are covered, as also disclosed in the above-mentioned US-provision application having the serial number 60/684,602, with a quarter-wave-plate 54b (which may be applied e.g. by optical wringing and may be made of a suited material such as e.g. MgF₂ or SiO₂), wherein the orientation of the fast axis is denoted with "a" (in an alternate embodiment, "a" may refer to the slow axis). Since this quarter-wave-plate 54b is passed twice by each light beam being reflected on the respective position of the side face of the light mixing rod 50b, any such light beams passes, in total, a half-wave-plate causing a phase shift between two perpendicular polarization states of 180°.

Fig. 3 shows an arrangement which can be alternatively used instead of the light mixing rods of Fig. 1 or Fig. 2. According to Fig. 3, in addition to a first light mixing rod 303 a second light mixing rod 305 is mounted along the optical axis OA downstream of the first light mixing rod 303. Furthermore, a half-wave-retardation plate 307 is arranged along the optical axis OA between the first light mixing rod 303 and the second light mixing rod 305. The light mixing rods 303 and 305 have substantially identical geometrical dimensions, are made from CaF₂-material and have, like the light mixing rods of Fig. 1 and Fig. 2, their respective entry face, exit face and side faces oriented substantially perpendicular to the [100]-crystal axis of the CaF₂-crystal material. The half-wave-retardation plate 307 can be made e.g. from MgF₂ with the fast axis being inclined at 45° to the x-axis. The half-wave-retardation plate 307 may also be seamlessly inserted between the light mixing rods 303 and 305; furthermore, it may be replaced by a 90°-rotator consisting of two half-wave plates being rotated by 45° relative to each other.

As a result of the presence of the half-wave-retardation plate 307, the directions of two orthogonal states of polarization are rotated between the light mixing rods 303 and 305 by 90°, which means that they are in effect exchanged with respect to each other. Consequently, for a light beam 311 which is passing both the light mixing rods 303 and 305, an optical path difference collected while traversing the second light mixing rod 305 has the opposite sign compared to an optical path difference which was collected while traversing the first light mixing rod 303, so the cumulative optical path difference over the two light mixing rods 303 and 305 will be at least substantially compensated.

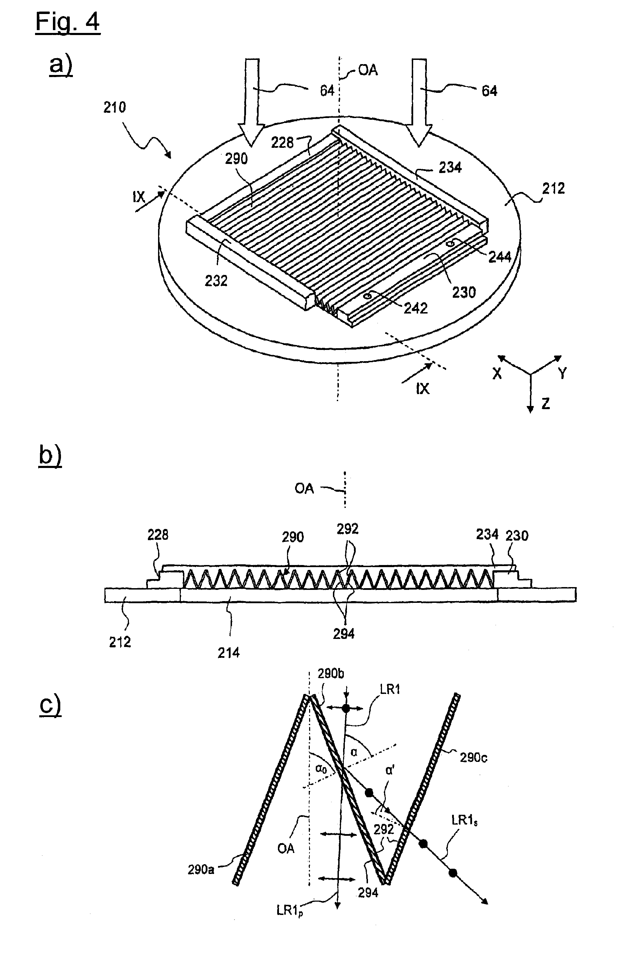

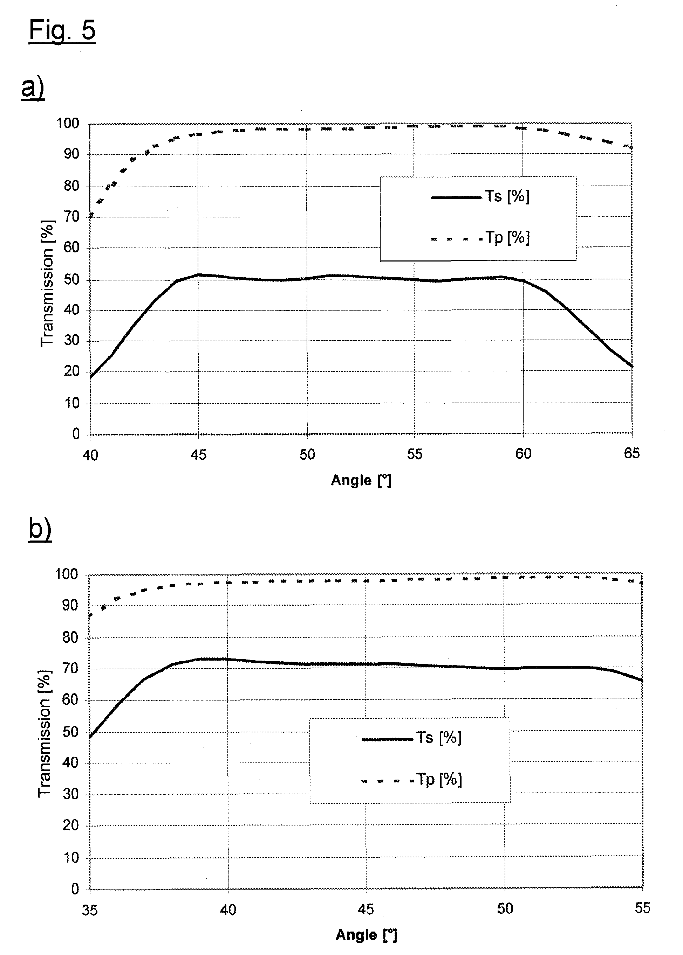

As has been explained above, the illumination system according to the present invention enables an enhanced preservation of the polarization state of linear polarized light passing through the illumination system. In order to further optimize this preservation of the polarization state on the light path towards the reticle, a further polarizer may be arranged e.g. in the pupil plane of the REMA-objective 70 of Fig. 1. Different constructions of polarizers have been disclosed e.g. in WO 2005/024516 A2 or US 2005/0140958 A1, which polarizers are able to transform non polarized light into a desired polarization state with an IPS-factor of more than 98%. The IPS-factor (IPS= "Intensity in Preferred State") is defined as the light intensity present in the desired or targeted polarization state and the target pupil region divided by the total intensity in the target pupil region. A typical construction of such a polarizer as disclosed in WO 2005/024516 A2 or US 2005/0140958 A1 is illustrated in Fig. 4 and 5 and explained in more detail further below.

On the other hand, it has been found that a polarizer having a large extinction ratio (being defined as the ratio of the intensity of the p-polarized light and the intensity of the s-polarized light, respectively, i.e. Tₚ/Tₛ) causes, if it is arranged e.g. in a pupil plane of the REMA-objective 70 of the illumination system 100 of Fig. 1, an undesired intensity variation in field downstream of said polarizer, which is a consequence of the polarization variation in field upstream of said polarizer. With other words, a polarizer having a large extinction ratio of e.g. more than 10 transforms illumination light having - upstream of the polarizer- a uniform intensity or energy distribution and a non-uniform polarization distribution into light having -downstream of the polarizer- a substantially uniform polarization distribution and a non-uniform intensity or energy distribution.

To overcome this problem, a polarizer being arranged e.g. in a pupil plane of the REMA-objective 70 of the illumination system 100 according to a further embodiment of the present invention has a relatively low extinction ratio. In the context of the present invention, an extinction ratio is regarded as relatively low if its value does not exceed a value of 10, more preferably 5. In preferred embodiment, said extinction ratio does not exceed a value of 2. It has been found by the inventors that a polarizer having an extinction value of ≈1.7 may provide for an enhancement of the value of the IPS-factor from 85% (without said polarizer) to a value of 90% (with polarizer), which again can be regarded in many situations as sufficient to provide for a satisfying imaging quality provided by the illumination system. With such a restriction of the extinction ratio of a polarizer being used in the pupil plane of the REMA-objective 70 to relatively small values, the invention takes account for the fact that the inventive illumination system of e.g. Fig. 1 already provides for a relatively good preservation of the state of polarization even without said polarizer. The achieved advantageous effect of the restriction of the extinction ratio of the polarizer is that an undesired intensity variation in field of the light downstream of said polarizer is at least substantially avoided.

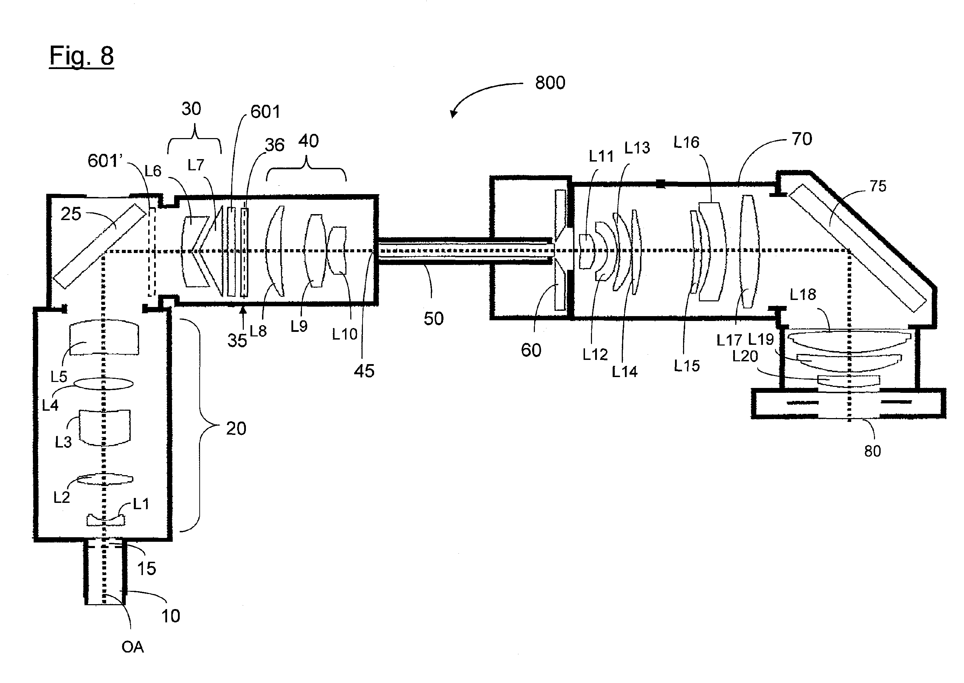

Regarding the principal mechanical structure of such a polarizer, reference can be made to e.g. WO 2005/024516 A2 or US 2005/0140958 A1 and the examples given therein, an example of which being illustrated in Fig. 4a-c of the present application (corresponding to Fig. 8, 9 and 11 of US 2005/0140958 A1. For a more detailed description, reference is made to the aforementioned publications.

Fig. 4a-b show the principal arrangement of such a polarizer 210 in a perspective view (Fig. 4a) and in a horizontal section (Fig. 4b) along the line IX-IX, respectively. The polarizer 210 has a circular assembly plate 212 which is provided with a central rectangular opening 214 and can be introduced into the optical beam path, e.g. by insertion into a filter holder. A multiplicity of supporting elements 290a,b consisting of thin plane-parallel quartz glass plates and being arranged to form elongated rectangles 290 in the Y direction extend across the opening 214. The arrangement of supporting elements 290a,b is limited in the X direction by two stops 228 and 230. The stop 230 is fixed detachably to the assembly plate 212 by means of two fixing elements 242, 244. The supporting elements 290a,b are fixed in the Y and Z directions by two rails 232 and 234 in which zigzag-shaped grooves facing towards the supporting elements 290a,b are formed. The short transverse sides of the supporting elements 290a,b are inserted in these grooves and bonded or otherwise fixed. In this way the supporting elements 290a,b are retained in an inclined position with respect to one another.

Each supporting element 290 supports on its upper and/or lower face a respective polarization-selective beam splitting layer 292, 294, as specified in more detail below. FIG. 4c shows an enlarged portion of the cross-section through the supporting elements 290a, 290b illustrated in FIG. 4b. Each of the supporting elements 290a,b is arranged at an inclination to the optical axis OA such that the angle between the optical axis OA and the normals on the supporting elements 290a,b corresponds to α₀. In the following, exemplarily embodiments of a polarization-selective beam splitting layer for use in the polarizer of Fig. 4a are given such that the resulting polarizer exhibits an extinction value of not more than ≈2. To this, Tables 10 and 11 include suitable layer designs, wherein the respective layer sequence is described such that "H" represents a first material having a relatively large refractive index such as LaF₃, NdF₃, Al₂O₃, DyF₃ or GdF₃. "L" represents a second material having a relatively low refractive index such as Chiolith, Kryolith, AlF₃ or MgF₂. The thickness of each layer is given in terms of optical thickness dₒₚₜ, with dₒₚₜ = n*d/λ (n=refractive index, d=geometrical thickness, λ= operating wavelength).

**Table 10:**

| | |
|---|---|
| Layer design according to 1^{st} embod. (Fig. 5a) : | |

| **Optical thickness** | **Material** |
|---|---|
| Substrate | SiO₂ |
| 0,28 | H |
| 0,32 | L |
| 0,17 | H |
| 0,28 | L |
| 0,11 | H |
| 0,34 | L |
| 0,26 | H |
| 0,27 | L |
| 0,27 | H |
| 0,26 | L |
| 0,27 | H |
| 0,25 | L |
| 0,27 | H |
| 0,25 | L |
| 0,26 | H |
| 0,24 | L |
| 0,25 | H |
| 0,24 | L |
| 0,25 | H |
| 0,25 | L |
| 0,27 | H |
| 0,29 | L |
| 0,31 | H |
| 0,34 | L |
| 0,36 | H |
| 0,40 | L |
| 0,37 | H |
| 0,35 | L |
| 0,32 | H |
| 0,32 | L |
| 0,07 | H |

**Table 11:**

| | |
|---|---|
| Layer design according to 2^{nd} embod. (Fig. 5b): | |

| **Optical thickness** | **Material** |
|---|---|
| Substrate | SiO₂ |
| 0,27 | L |
| 0,23 | H |
| 0,25 | L |
| 0,13 | H |
| 0,27 | L |
| 0,24 | H |
| 0,26 | L |
| 0,26 | H |
| 0,25 | L |
| 0,26 | H |
| 0,25 | L |
| 0,26 | H |
| 0,24 | L |
| 0,25 | H |
| 0,24 | L |
| 0,24 | H |
| 0,23 | L |
| 0,23 | H |
| 0,25 | L |
| 0,26 | H |
| 0,29 | L |
| 0,30 | H |
| 0,34 | L |
| 0,37 | H |
| 0,41 | L |
| 0,34 | H |
| 0,33 | L |
| 0,29 | H |
| 0,30 | L |
| 0,06 | H |

In the first embodiment of the polarizer having a polarization-selective beam splitting layer according to Table 10, only one side of each supporting element is provided with the polarization-selective beam splitting layer, while the other side is provided with an antireflective coating. The angle α₀ between adjacent plates is 52°, and the usable region for the incidence angle is ±8°, i.e. α ranges from 44 to 60°. As can be gathered from Fig. 5a showing the dependence of the transmission coefficients Tₛ or Tₚ, respectively, on the incidence angle for the polarizer according to the first embodiment, Tₚ in this angular region is close to 100 %, whereas Tₛ is close to 50 %, so that the achieved value for the extinction coefficient Tₚ/Tₛ is ≈ 2.

In the second embodiment of the polarizer having a polarization-selective beam splitting layer according to Table 11, both sides of each supporting element are provided with the polarization-selective beam splitting layer. However, since the polarization-selective of this layer is weaker compared to that according to Table 10, the resulting total polarization-selective effect is comparable. The angle α₀ between adjacent plates is 46°. As can be gathered from Fig. 5b showing the dependence of the transmission coefficients Tₛ or Tₚ, respectively, on the incidence angle for the polarizer according to the second embodiment, Tₚ in this angular region is close to 100 %, whereas Tₛ is close to 70 %, so that the achieved value for the extinction coefficient Tₚ/Tₛ is ≈ 1.43.

In a further embodiment, the illumination system may further comprise an intensity filter (such as a grey filter) mounted on said optical axis downstream of said light mixing rod, which may be arranged directly on said polarizer (e.g. as a grey scale profile). By means of using such a spatially varying intensity filter, it is possible to provide (at least in average) for a uniform intensity distribution, e.g. regarding the poles of a used illumination setting downstream of the polarizer. Such an intensity filter may be e.g. arranged directly on said polarizer and accounts for the fact that e.g. in illumination settings having more than two poles (e.g. a so-called "C-quad-setting" with two poles on the x-axis and two poles on the y-axis), a non point-symmetric intensity distribution may be caused by the polarizer which may result in energetic offsets (pole balance, ellipticity) in the pupil plane.

In the following, a further embodiment of the present invention is described which may be used to provide, in the pupil plane downstream of the light mixing rod (i.e. in the pupil plane within the REMA-objective), regions of different polarization degrees. Such polarization distributions with a locally varying polarization degree in said pupil plane, i.e. a locally varying residual polarisation, as described in the following in more detail, may e.g. be suitable if the structures which are present in the reticle plane (where the light rays emerging of said pupil plane overlap) and which are to be imaged by the projection lens of the projection exposure apparatus comprise both strongly orientated structures like line structures and less strongly orientated structures like electrical contacts or peripheral structures (e.g. hole structures).

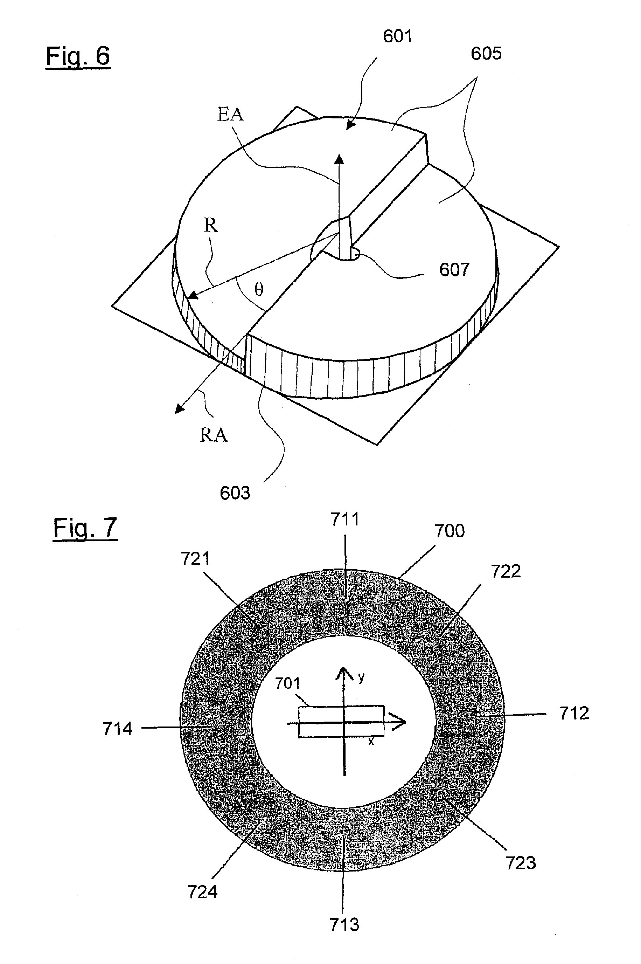

Fig. 6 shows a polarization-modulating optical element 601, which is principally known from WO 2005/069081 A2 and which is arranged in an illumination system of the present invention according to a further embodiment. More specifically, the polarization-modulating optical element 601 may be arranged in the illumination system 800 as schematically illustrated in Fig. 8.

The illumination system 800 of Fig. 8 has the same structure and components as the illumination system 100 of Fig. 1, and only differs from the illumination system 100 by additionally comprising the polarization-modulating optical element 601 at a position between elements L7 and 36. Although this position of element 601 is a preferred position due to fact that the maximum angles of the light rays with the optical axis are relatively small at this position, the polarization-modulating optical element 601 may be alternatively arranged also at other positions, e.g. upstream of the lens L6 as it is also shown in Fig. 8 (at which the position of such a polarization-modulating element 601' is illustrated with broken lines).

As disclosed in WO 2005/069081 A2, the polarization-modulating optical element 601 serves for transforming an entering light bundle with a linear polarization distribution into an exiting light bundle with a tangential polarization distribution, i.e. a polarization distribution where the planes of oscillation of the electrical field vectors of individual linearly polarized light rays in a pupil plane of the system have an orientation that is perpendicular to the radius originating from the optical axis.

To this, the polarization-modulating optical element 601 is made of optically active crystal, in particular quartz, and has a thickness profile which, as measured in the direction of its element axis EA (or the optical axis OA of the optical system wherein said element 601 is arranged), is variable.

More specifically, the polarization-modulating optical element 601 has a cylindrical shape with a base surface 603 designed as a planar circular surface, and an opposite surface 605 having a contour shape in relation to the element axis EA in accordance with a given thickness profile, as described in the above-mentioned reference WO 2005/069081 A2. The element axis EA (and the optical system axis OA of the illumination system 800, in which the polarization-modulating optical element 601 is arranged according to Fig. 8) extends perpendicular to the planar surface, and the optical crystal axis of the optically active quartz runs parallel to the element axis EA. The reference axis RA, which extends in the base plane, intersects the element axis EA at a right angle and serves as the reference from which the azimuth angle θ is measured. In the special configuration illustrated in Fig. 6, the thickness of the polarization-modulating optical element 601 is constant along a radius R that is perpendicular to the element axis EA and directed at an angle θ relative to the reference axis RA. Thus, the thickness profile in the illustrated embodiment of Fig. 6 depends only on the azimuth angle θ. The optical element 601 has an optional central bore 807 coaxial with the element axis EA. Alternate embodiments of the polarization-modulating optical element 601 described in the above-mentioned reference WO 2005/069081 A2 and transforming an entering light bundle with a linear polarization distribution into an exiting light bundle with an at least tangential polarization distribution may be used as well instead of the specific embodiment shown in Fig. 6.

Fig. 7 schematically shows, in order to explain the combined effect of the polarization-modulating optical element 601 and the light mixing rod 50, i.e. the effect of the tangential polarization distribution provided by the polarization-modulating optical element 601 at the entrance to the light-mixing rod 50 of Fig. 8, for an annular illumination setting a pupil 700 provided in the pupil plane downstream of the light mixing rod 50 (i.e. in the pupil plane within the REMA-objective) and comprising regions of different polarization degrees, together with a schematic representation of the contours 701 of the light mixing rod 50. In the regions 711 and 713 of the pupil 700, the light will be polarized parallel to the x-axis, while in regions 712 and 714 it will be polarized parallel to the y-axis. Consequently, it will be transmitted by the light mixing rod 50 with preservation of the polarization state as described above. However, in regions 721, 722, 723 and 724 of the pupil 700 the orientation of polarization describes, at the entrance of the light-mixing rod 50 and as an effect of the tangential polarization distribution provided by the polarization-modulating optical element 601, an angle of 45° with the side faces of the light-mixing rod 50. Since for this orientation the light mixing rod 50 does not preserve the polarization state as described above, said light is modified in its polarization state due to phase shifts caused by total reflections within the light mixing rod 50, wherein this modification again varies depending on the distance travelled in the rod.

As a result, the light of said regions 721-724 of the pupil 700 will be depolarized or it will yield depolarized light at least after the scanning performed during the microlithography process. Furthermore, and as a consequence of the continuous modification of the polarization state caused by the polarization-modulating optical element 601, the depolarization will continuously increase from regions 711-714 to regions 721-724. Accordingly, the annular pupil 700 of Fig. 7 exhibits regions of different polarization degrees, i.e. a locally varying residual polarization. Further, this depolarization, which has been described before and which occurs if the orientation of polarization at the entrance of the light mixing rod do not match with the Eigen-states of any existing stress-induced birefringence in the light mixing rod, will be particularly pronounced for a light mixing rod whose side faces are, as for the light mixing rod 50 of Fig. 8, perpendicular to a [100]-crystal axis of the cubic crystal material of said light mixing rod 50 and which exhibits a stress-induced birefringence perpendicular to said side faces.

As follows from the above explanations and in a more general aspect of the embodiment described with reference to Fig. 6-8, the intrinsic property of the light mixing rod to preserve or modify the polarization state of light transmitted there through may be used in combination with a polarization-modulating optical element to provide a polarization distribution which exhibits a locally varying residual polarization degree across the pupil in the pupil plane downstream of the light mixing rod and which partially yields, at least after the scanning performed during the microlithography process, depolarized light.

The above description of preferred embodiments has been given by way of example. A person skilled in the art will, however, not only understand the present invention and its advantages, but will also find suitable modifications thereof. Therefore, the present invention is intended to cover all such changes and modifications as far as falling within the spirit and scope of the invention as defined in the appended claims and the equivalents thereof.

## Claims

1. An illumination system of a microlithographic exposure system, said illumination system having an optical axis and comprising:
• at least one light mixing rod made from a cubic crystal material and having an entry face, an exit face and side faces, wherein said light mixing rod mixes light of a light beam, said light beam being emitted by a light source during operation of said microlithographic exposure system, via multiple internal reflections at said side faces and wherein said entry face and said exit face of said light mixing rod are oriented substantially perpendicular to a [100]-crystal axis of said cubic crystal material; and
• an optical system mounted along said optical axis upstream of said light mixing rod and transmitting light of said light beam to said entry face of said light mixing rod, wherein said optical system comprises at least two lenses made from a cubic crystal material, wherein said at least two lenses have its [111]-crystal axes aligned along said optical axis and are rotated against each other with respect to said optical axis.

2. The illumination system according to claim 1, wherein said illumination system comprises exactly one light mixing rod.

3. The illumination system according to claim 1 or 2, wherein said side faces of said light mixing rod are oriented substantially perpendicular to a [100]-crystal axis of said cubic crystal material of said light mixing rod.

4. The illumination system according to anyone of the claims 1 to 3, further comprising an optical assembly mounted on said optical axis downstream of said light mixing rod and including a reticle masking system and a reticle masking objective, said reticle masking objective imaging an intermediate field plane of said reticle masking system onto a reticle plane, wherein at least one, in particular exactly one lens in said reticle masking objective is made from a cubic crystal material and has its [100]-crystal axis aligned along said optical axis.

5. The illumination system according to anyone of the claims, wherein said cubic crystal material of said light mixing rod and/or said cubic crystal material of said lenses is a fluoride-crystal material, preferably calcium-fluoride (CaF₂).

6. The illumination system according to anyone of the claims 1, 3, 4 and 5, further comprising in addition to said first light mixing rod a second light mixing rod mounted along said optical axis downstream of said first light mixing rod as well a half-wave-retardation plate, said half-wave-retardation plate being arranged along said optical axis between said first and said second light mixing rod.

7. The illumination system according to claim 6, wherein said second light mixing rod is also made from a cubic crystal material and has a second entry face, a second exit face and second side faces, wherein said second entry face and said second exit face of said second light mixing rod are oriented substantially perpendicular to a [100]-crystal axis of said cubic crystal material.

8. The illumination system according to claim 7, wherein said second side faces of said second light mixing rod are oriented substantially perpendicular to a [100]-crystal axis of said cubic crystal material.

9. The illumination system according to anyone of the preceding claims, wherein said first and/or said second side faces are provided with a coating, wherein said coating is prepared such that for linear polarized light of said light beam entering said entry face of said light mixing rod the state of polarization is substantially preserved when leaving said exit face of said light mixing rod.

10. The illumination system according to claim 9, wherein said coating is a dielectric coating that causes, for a light beam being reflected thereon while passing said light mixing rod, a phase shift between two orthogonal polarization states in the range from 130° to 230°, more preferably in the range from 155° to 205°, and still more preferably of substantially 180°.

11. The illumination system according to anyone of the preceding claims, further comprising at least one optical element selected from the group that consists of diffractive optical element, refractive optical element, diffusion panel or grey filter, wherein said at least one optical element consists of or comprises either a fluoride-crystal material, preferably calcium-fluoride (CaF₂), or crystalline quartz (SiO₂).

12. The illumination system according to claim 11, comprising at least one diffusion panel mounted at said entry side of said first and/or second light mixing rod and being made either from a fluoride-crystal material, preferably calcium-fluoride (CaF₂), or crystalline quartz (SiO₂).

13. The illumination system according to anyone of the preceding claims, wherein said optical system comprises along said optical axis a zoom objective, an adjustable axicon and an in-coupling optic coupling light of said light beam into said light mixing rod.

14. The illumination system according to claim 13, comprising a diffractive optical element mounted in an object plane of said zoom objective and being made either from a fluoride-crystal material, preferably calcium-fluoride (CaF₂), or crystalline quartz (SiO₂).

15. The illumination system according to claim 13 or 14, comprising a refractive optical element mounted in an exit pupil plane of said zoom objective and being made either from a fluoride-crystal material, preferably calcium-fluoride (CaF₂), or crystalline quartz (SiO₂).

16. The illumination system according to anyone of the claims 13 to 15, comprising at least one grey filter mounted in an exit pupil plane of said zoom objective and having a substrate made either from a fluoride-crystal material, preferably calcium-fluoride (CaF₂), or crystalline quartz (SiO₂).

17. The illumination system according to anyone of the preceding claims, further comprising a polarizer mounted at a position along said optical axis downstream of said light mixing rod and having an extinction ratio a value of which does not exceed a value of 10, more preferably a value of 5.

18. The illumination system according to claim 17, wherein said extinction ratio does not exceed a value of 2.0, more preferably a value of 1.85, and still more preferably a value of 1.7.

19. The illumination system according to claim 17 or 18, wherein said polarizer is arranged in a pupil plane of said reticle masking objective.

20. The illumination system according to anyone of the claims 17 to 19, further comprising an intensity filter mounted on said optical axis downstream of said light mixing rod.

21. The illumination system according to claim 20, wherein said intensity filter is arranged directly on said polarizer.

22. The illumination system according to anyone of the preceding claims, further comprising upstream of said light mixing rod a polarization-modulating optical element which transforms an entering light bundle with a linear polarization distribution into an exiting light bundle with an at least approximately tangential polarization distribution.

23. The illumination system according to claim 22, wherein said polarization-modulating optical element is made of an optically active crystal material, wherein an optical crystal axis of said optically active crystal material is parallel to said optical axis of said illumination system, and wherein said polarization-modulating optical element has a thickness profile which, as measured in the direction of said optical axis, is variable.

24. An illumination system of a microlithographic exposure system, said illumination system having an optical axis and comprising
• a reticle masking system and a reticle masking objective, said reticle masking objective imaging an intermediate field plane of said reticle masking system onto a reticle plane; and
• a polarizer mounted at a position along said optical axis downstream of said light mixing rod and having an extinction ratio a value of which does not exceed a value of 10, more preferably a value of 5.

25. The illumination system according to claim 24, wherein said extinction ratio does not exceed a value of 2.0, more preferably a value of 1.85, and still more preferably a value of 1.7.

26. An illumination system of a microlithographic exposure system, said illumination system having an optical axis and comprising:
• a light mixing rod having an entry face, an exit face and side faces, wherein said light mixing rod mixes light of said light beam, said light beam being emitted by a light source during operation of said microlithographic exposure system, via multiple internal reflections at said side faces;
• an optical system mounted along said optical axis upstream of said light mixing rod and transmitting light of said light beam to said entry face of said light mixing rod; and
• an optical assembly mounted along said optical axis downstream of said light mixing rod and including a reticle masking system and a reticle masking objective;
• wherein exactly one lens in said reticle masking objective is made from a cubic crystal material and has its [100]-crystal axis aligned along said optical axis.

27. Method of microlithographically structuring a substrate comprising the steps of illuminating a mask with light and projecting an image of said mask onto said substrate, wherein said step of illuminating a mask with light uses an illumination system according to anyone of the preceding claims.

28. A microstructured device, **characterized in that** it is fabricated according to the method of claim 27.
